# EUROPEAN PATENT SPECIFICATION

(11) **EP 4 131 342 B1**
(45) Date of publication and mention of the grant of the patent: **26.02.2025**
(21) Application number: 21775673.3
(22) Date of filing: 23.03.2021
(51) Int. Cl.: H01L 29/47, H01L 21/28

(54) **WIDE GAP SEMICONDUCTOR DEVICE AND METHOD FOR MANUFACTURING WIDE GAP SEMICONDUCTOR DEVICE**
HALBLEITERBAUELEMENT MIT BREITEM SPALT UND VERFAHREN ZUR HERSTELLUNG EINES HALBLEITERBAUELEMENTS MIT BREITEM SPALT
DISPOSITIF À SEMI-CONDUCTEUR À LARGE BANDE INTERDITE ET PROCÉDÉ DE FABRICATION DE DISPOSITIF À SEMI-CONDUCTEUR À LARGE BANDE INTERDITE

(30) Priority: 27.03.2020 JP 2020057741
(43) Date of publication of application: 08.02.2023
(73) Proprietor: Shindengen Electric Manufacturing Co., Ltd., Tokyo 100-0004 (JP)
(72) Inventor: MAEYAMA, Yusuke, Hanno-shi, Saitama 357-8585 (JP); NAKAMURA, Shunichi, Hanno-shi, Saitama 357-8585 (JP); ONUKI, Jin, Hanno-shi, Saitama 357-8585 (JP)
(74) Representative: Schwarz & Partner Patentanwälte GmbH
(86) International application number: PCT/JP2021/011984
(87) International publication number: WO 2021/193629

(56) References cited:
- JP-A- 2006 237 393
- JP-A- 2013 161 805
- JP-A- 2017 112 585
- JP-A- H09 129 901
- US-A1- 2015 129 896
- US-A1- 2017 117 376
- MASSABUAU F ET AL: "Study of Ti contacts to corundum [alpha]-Ga2O3", JOURNAL OF PHYSICS D: APPLIED PHYSICS, INSTITUTE OF PHYSICS PUBLISHING, BRISTOL, GB, vol. 54, no. 38, 8 July 2021 (2021-07-08), pages 384001, XP020369031, ISSN: 0022-3727, [retrieved on 20210708], DOI: 10.1088/1361-6463/AC0D28
- WALDROP, J. R. ET AL.: "Schottky barrier height and interface chemistry of annealed metal contacts to alpha 6H-SiC: Crystal face dependence", APPLIED PHYSICS LETTERS, vol. 62, 1993, pages 2685 - 2687, XP002179930

## Description

### Technical Field

The present invention is related to wide gap semiconductor device and method for manufacturing wide gap semiconductor device.

### Background Art

Conventionally, a wide gap semiconductor device using silicon carbide or the like has been known (see, for example, Japanese Patent Application Laid-Open No. 2015 - 56543). In the wide gap semiconductor device, there is a need to lower an on-voltage of a Schottky barrier diode (SBD). Since most of the on-voltage of an SBD is due to a built-in voltage derived from Schottky junction, the on-voltage can be effectively lowered by lowering ϕB (Schottky barrier).

When n-type silicon carbide, which is a kind of wide gap semiconductor device, is taken as an example, ϕBn of SiC-SBD is generally controlled by a Schottky electrode, and Ti, Ni, Pt, or the like is used as the Schottky electrode of SiC-SBD. Among them, Ti is known to have the smallest ϕBn, and most of commercially available n-type SiC-SBDs use Ti as the Schottky electrode.

If the conventionally used electrode is changed, an etching step needs to be changed in addition to a deposition step itself. Therefore, there is a demand to lower ϕB without changing the material of the SBD electrode.

JP 2013 161805 A and US 2013/196494 A1 disclose a method for manufacturing a silicon carbide semiconductor. Heat treatment is performed at a crystal recovery temperature to promote the recovery of crystal defects in the metal layer. Heat treatment is performed at 450°C ±50°C.

### SUMMARY OF INVENTION

### PROBLEM TO BE SOLVED BY INVENTION

The present invention provides a wide gap semiconductor device capable of lowering ϕB without changing the material of a metal layer that has been conventionally used.

### EFFECT OF INVENTION

In the present invention, when an aspect is adopted in which: a single crystal layer is provided in an interface region having a thickness of up to 30 nm from the interface between a wide gap semiconductor layer and a metal layer; and when it is assumed that a lattice constant, in an equilibrium state, of the C-axis of a metal constituting the metal layer is L, the interface region includes first region in which a C-axis lattice constant L1 is smaller than L by 1.5% to 8%, ϕB can be lowered.

### BRIEF DESCRIPTION OF DRAWINGS

Fig. 1 is a side sectional view of an n-type silicon carbide semiconductor device that can be used in an embodiment of the present invention.
Fig. 2(a) is a side sectional view showing an aspect in which intervals between constituent atoms are uniform in a single crystal layer, and Fig. 2(b) is a side sectional view showing an aspect in which intervals between constituent atoms are not uniform in a single crystal layer.
Fig. 3 is a graph showing a relationship between a C-axis lattice constant L1 in a single crystal layer containing Ti and a cumulative probability plot in an aspect in which annealing temperatures of Ti are different.
Fig. 4 is a graph showing a relationship between the C-axis lattice constant L1 in the single crystal layer containing Ti and ϕBn (eV) in an n-type silicon carbide device.
Fig. 5 is a graph showing a relationship between the C-axis lattice constant L1 in the single crystal layer containing Ti and Ef (eV) in a silicon carbide device, the relationship being obtained by theoretical calculations.
Fig. 6 is a graph showing a relationship between the C-axis lattice constant L1 in the single crystal layer containing Ti and an n value in the silicon carbide device.
Fig. 7 is a graph showing a relationship between an annealing time of a metal electrode containing Ti at 450°C and ϕBn (eV) in a manufactured n-type silicon carbide device.
Fig. 8 is a graph showing a relationship between a Ti deposition rate and ϕBn (eV) in the manufactured n-type silicon carbide device.
Fig. 9 are images respectively showing a cross-sectional TEM image at 600,000x magnification, a cross-sectional TEM image at 3,000,000x magnification, and a selected-area electron diffraction pattern.

### EMBODIMENT OF THE INVENTION

### Embodiment

### <<Configuration>>

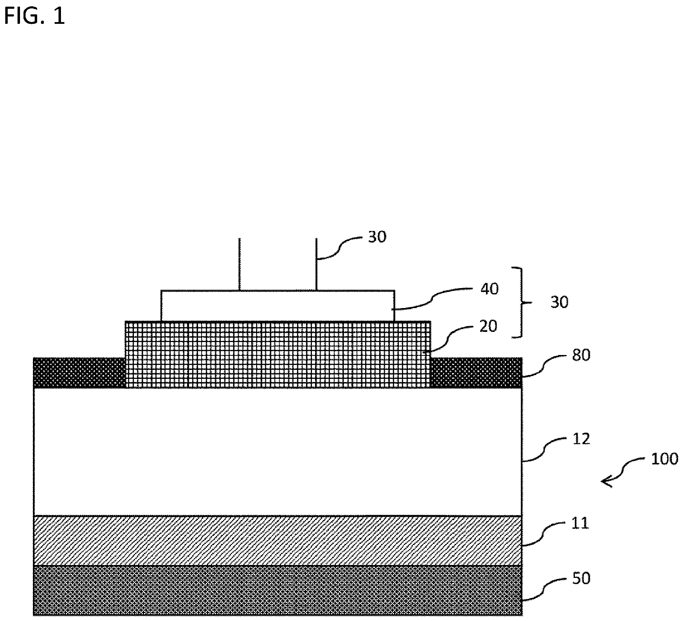

In the present embodiment, "one side" means a front surface side that is the upper side in Fig. 1, and "the other side" means a back surface side that is the lower side in Fig. 1.

The present embodiment will be described by using an n-type silicon carbide semiconductor device (hereinafter, simply referred to as a "silicon carbide semiconductor device") A special silicon carbide substrate may be adopted in which a single crystal silicon carbide layer is formed on polycrystalline silicon carbide.

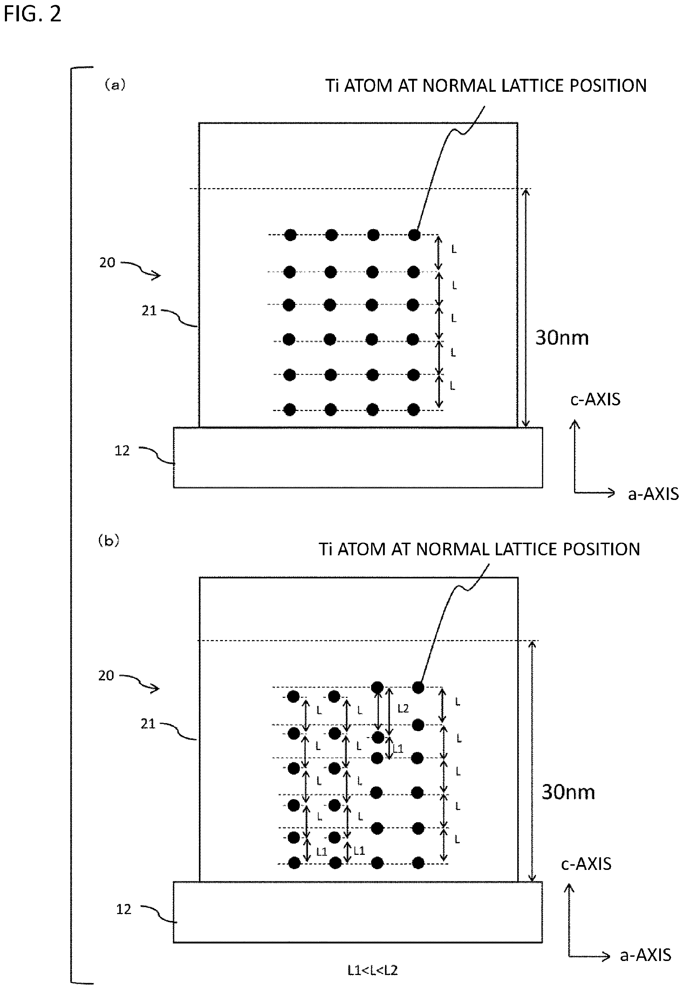

As shown in Fig. 1, the silicon carbide semiconductor device has a silicon carbide substrate 11, a silicon carbide layer 12 provided on the one side (front surface side) of the silicon carbide substrate 11, and a metal electrode 20 that is a metal layer provided on the one side of the silicon carbide layer 12 to function as a front surface electrode. Note that as an example in the aspect shown in Fig. 1, the silicon carbide layer 12 is directly provided on the silicon carbide substrate 11, and the metal electrode 20 is directly provided on the silicon carbide layer 12. As shown in Figs. 2(a) and 2(b), the metal electrode 20 has a single crystal layer 21 in an interface region at an interface with the silicon carbide layer 12. When it is assumed that a lattice constant, in an equilibrium state, of the C-axis of a metal constituting the metal electrode 20 is L, the single crystal layer 21 in the interface region may include first region in which a C-axis lattice constant is smaller than L by 1.5% to 8% (each having L1). The single crystal layer 21 may be formed by heteroepitaxial growth.

In the present embodiment, the "interface region" in the metal electrode 20 means a region in the range of 30 nm from the interface between the metal electrode 20 and the silicon carbide layer 12, in the thickness direction, toward the metal electrode 20 (the one side). On the further one side of the interface region of the metal electrode 20, the metal electrode 20 may have a single crystal structure, a polycrystalline structure, or an amorphous structure.

As shown in Fig. 1, the metal electrode 20 may be provided with a connection electrode 40. In addition, the connection electrode 40 may be provided with a connection part 30. The connection part 30 may be a wire or a connecting body.

The connection electrode 40 may contain aluminum, an aluminum alloy containing silicon, an aluminum alloy containing copper, titanium, or the like, or may include a laminated film of an aluminum alloy containing silicon, an aluminum alloy containing copper, or aluminum and titanium. Without being limited thereto, the connection electrode 40 may contain another metal such as copper, gold, or nickel.

A back surface electrode 50 may be provided on the other side (back surface side) of the silicon carbide semiconductor substrate 11. The back surface electrode 50 may contain nickel, titanium, or the like. An insulating layer 80, containing oxide or the like, may be provided in a region that is located on the one side (front surface side) of the silicon carbide layer 12 and in which a first electrode part 30 is not provided.

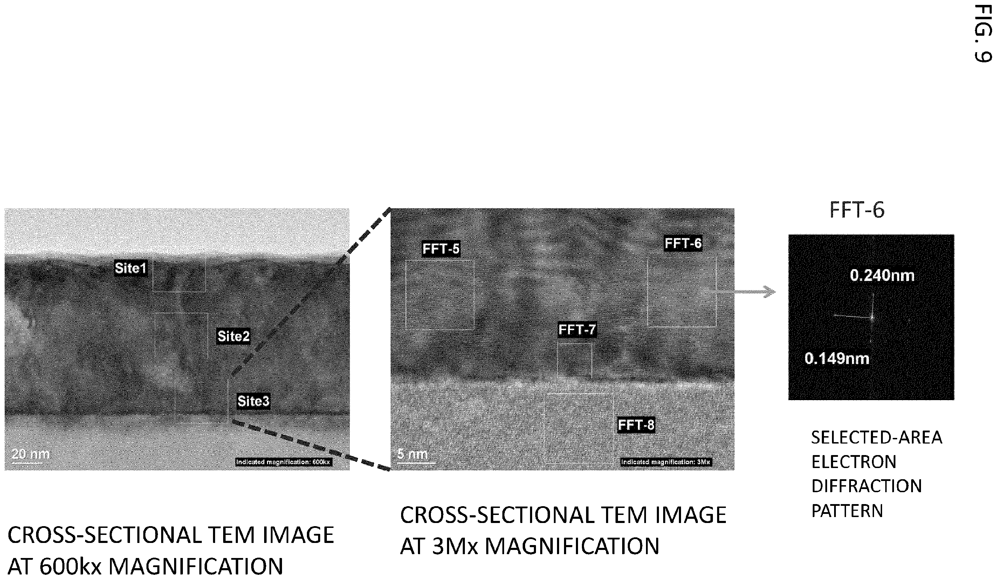

The single crystal layer 21 in the interface region may include the first region, in which the C-axis lattice constant is L1, at 20% or more, or may include the first region at 30% or more thereof. In the present embodiment, "containing the first region at A% or more" means that when one image is captured with a TEM, the first region in which the lattice constant is L1 can be confirmed at A% or more in all region (see Fig. 9). However, whether or not the first region is at 20% or more included may be confirmed by capturing a plurality of images (e.g., 2 to 10 images) with a TEM and using measurement results in the plurality of images.

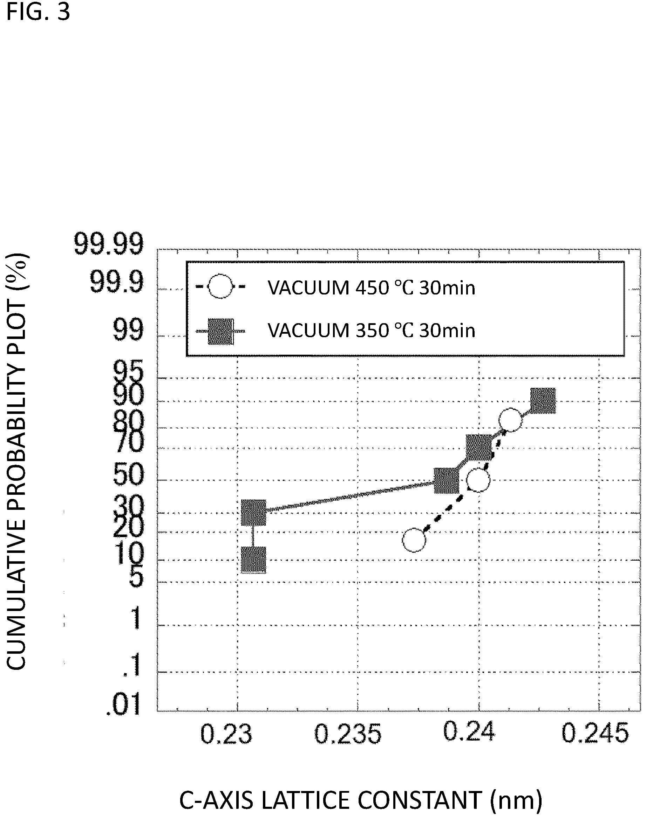

When the metal contains Ti, the lattice constant L in an equilibrium state is 0.24 nm. Therefore, the fact that the C-axis lattice constant L1 is smaller than L by 1.5% to 8% means that the C-axis lattice constant L1 falls within the range of 0.2208 nm to 0.2364 nm. Fig. 3 is a graph in which the cumulative probabilities of the C-axis lattice constant L1 are plotted. The graph shows that when annealing is performed at 450°C for 30 minutes in a vacuum state of 1E-4 Pa (1 × 10⁻⁴ Pa), the probability that the C-axis lattice constant L1 is about 0.236 nm or less is less than 20%, whereas when annealing is performed at 350°C for 30 minutes in a vacuum state of 1E-4 Pa, the probability that the C-axis lattice constant L1 is about 0.233 nm or less is 30%. TEM is used for the measurement, and the result is obtained by cross-sectional diffraction images (see Fig. 9). Fig. 9 shows a cross-sectional TEM image at 600,000x magnification, a cross-sectional TEM image at 3,000,000x magnification, and a selected-area electron diffraction pattern. The lattice constant L1 of the single crystal can be measured from the selected-area electron diffraction pattern.

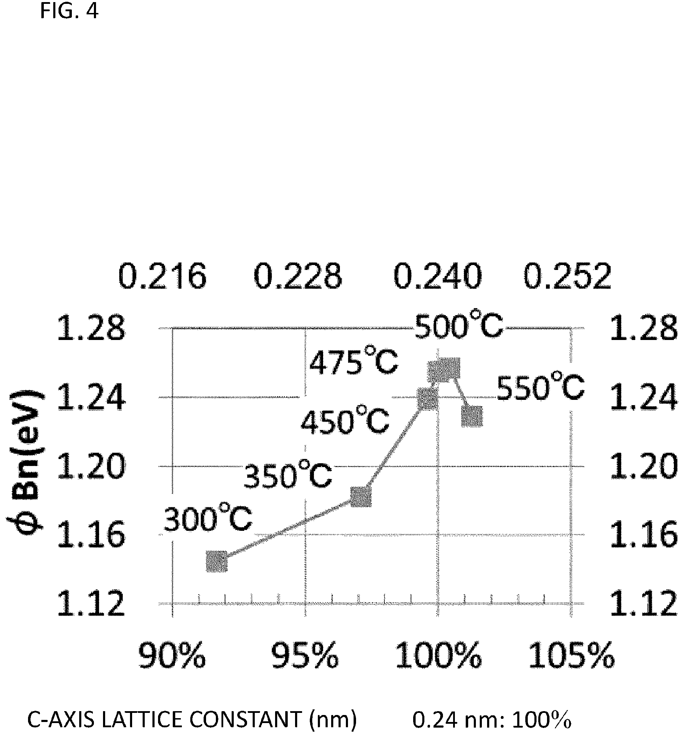

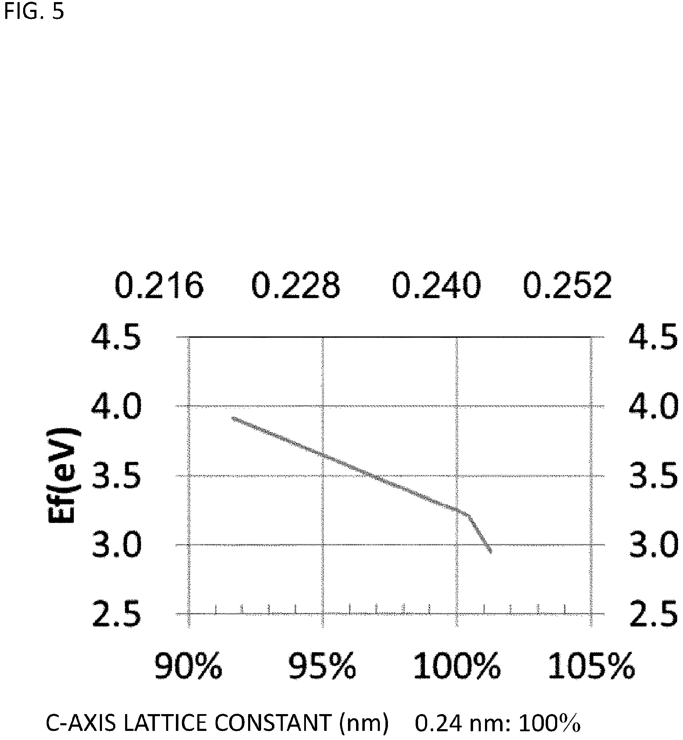

As confirmed by the inventors, it is found, as shown in Fig. 4, that ϕBn (eV) decreases as the C-axis lattice constant L1 decreases. It has also been confirmed, as shown in Fig. 5, that as a result of verification by first-principles calculations, the Fermi level (Ef) changes in a direction of lowering ϕBn by reducing the lattice constant. The value (C-axis lattice constant) on the horizontal axis shown in Fig. 4 represents a lattice constant when the cumulative probability is 30%. Note that there is the relationship that the larger Ef (eV), the smaller ϕBn (eV).

The crystal structure of the silicon carbide layer 12 may have a hexagonal structure, or may have a hexagonal close-packed structure. The crystal structure of the metal electrode 20 may have a hexagonal structure, or may have a hexagonal close-packed structure. The metal of the metal electrode 20 in the interface region may contain Ti. However, without being limited thereto, the metal of the metal electrode 20 in the interface region may include a metal containing Ti as a main component, or may include Ni, Pt, Mo, a metal containing Ni as a main component, a metal containing Pt as a main component, or a metal containing Mo as a main component. However, from the viewpoint that ϕBn can be lowered to a small value, it is advantageous to use the metal electrode 20 containing Ti or the metal electrode 20 including a metal containing Ti as a main component, and it is particularly advantageous to use the metal electrode 20 containing Ti. Note that the term "main component" means that it occupies 50% or more in mass percent, and the metal containing Ti as a main component means a metal containing 50 mass% or more of Ti.

Even when the metal of the metal electrode 20 in the interface region contains Ti, a metal layer containing Ni, Al, or the like may be provided on the one side of the electrode containing Ti.

The single crystal layer 21 in the interface region may include first region containing Ti in which the C-axis lattice constant L1 is 0.235 nm or less.

Next, an example of a manufacturing method will be described. In the following manufacturing example, an aspect will be described in which Ti is used as the metal electrode 20.

### (Manufacturing example 1)

A Ti layer is deposited on a substrate in which the silicon carbide layer 12 is provided on the silicon carbide substrate 11. For the deposition of the Ti layer, electron beam deposition may be used, or sputtering may be used. A deposition rate is, for example, 0.1 to 0.3 nm/s (e.g., 0.12 nm/s), and the degree of vacuum at the time of the deposition of the Ti layer is, for example, 1E-4 Pa to 1E-5 Pa (e.g., 1E-4 Pa).

Next, the substrate provided with the Ti layer is annealed (heated) at 350°C or lower. The substrate provided with the Ti layer is annealed, for example, at 350°C for 30 minutes to 60 minutes (e.g., 30 minutes). As a result, the metal electrode 20 including the Ti layer is generated.

Immediately after the Ti layer is deposited on the silicon carbide layer 12, vacancies are included in the Ti layer in the interface region between the silicon carbide layer 12 and the Ti layer. When the Ti layer is annealed, crystallized of Ti proceeds while the vacancies are diffused outward. It is considered that when the annealing temperature is set to 450°C to 500°C, perfect crystal Ti (equilibrium state) is obtained, and the C-axis lattice constant increases (see Fig. 2(a)). As a result, ϕBn is saturated at a large value.

On the other hand, when the annealing is performed at 350°C or lower (e.g., 350°C) as in the present embodiment, the vacancies in the Ti layer are suppressed from being diffused outward, so that a state of including many vacancies can be realized. As a result, it is considered that stress is generated in the Ti layer, and the intervals between the Ti atoms tend to be uneven (see Fig. 2(b)). Then, region (first region) in which a lattice constant is smaller than that at the time of complete crystallization and region (second region) in which a lattice constant is larger than that therein are both generated. When the number of the region (first region) in which a lattice constant is small is larger than the number of the region (second region) in which a lattice constant is large, ϕBn can be lowered.

Here, Figs. 2 are simplified views for understanding the above description. In a region including the atoms arranged on the right-most in Fig. 2(b), the interatomic distances between the arranged constituent atoms are constant L, and the average lattice constant in the C-axis direction is L. In a region including the atoms arranged second from the right in Fig. 2(b), the interatomic distances between the arranged constituent atoms are uneven by being divided into L1, L2, and L. L1 is smaller than L. L2 is larger than L. However, since the number of the regions, in each of which the interatomic distances are L1, and the number of the regions, in each of which the interatomic distances are L2, are equal, the average lattice constant of the lattice constants in the C-axis direction is L in this region. In a region including the atoms arranged third from the right in Fig. 2(b), the interatomic distances between the arranged constituent atoms are uneven by being divided into L1 and L. L1 is smaller than L. Therefore, the average lattice constant of the lattice constants in the C-axis direction is smaller than L in this region. In a region including the atoms arranged fourth from the right in Fig. 2(b), the interatomic distances between the arranged constituent atoms are uneven by being divided into L1 and L. L1 is smaller than L. Therefore, the average lattice constant of the lattice constants in the C-axis direction is smaller than L in this region.

As a result, when the aspect of Fig. 2(b) is viewed as a whole, the average lattice constant in the C-axis direction is smaller than L. Fig. 3 can be said to show an actual measurement result supporting this. Fig. 3 shows that when annealing is performed at 350°C or lower (here, 350°C), region (second region) in which the lattice constant in the C-axis direction is large exist (a plot exists at a location where the C-axis lattice constant is about 0.2425 nm), but region (first region) in which the lattice constant is small also exist (a plot also exists at a location where the C-axis lattice constant is about 0.2306 nm). And, it is shown that the number of the region (second region), in which the lattice constant is large, is smaller than the number of region (first region) in which the lattice constant is small. That is, the lattice constant in the C-axis direction decreases on average. As a result, ϕBn decreases as described above.

It can also be confirmed that the lattice constant decreases by the fact that when one image is captured with TEM, the first region occupies a wider region than the second region. Alternatively, it may also be confirmed that the first region occupies a wider region than the second region by capturing a plurality of images (e.g., 2 to 10 images) with TEM and using measurement results in the plurality of images.

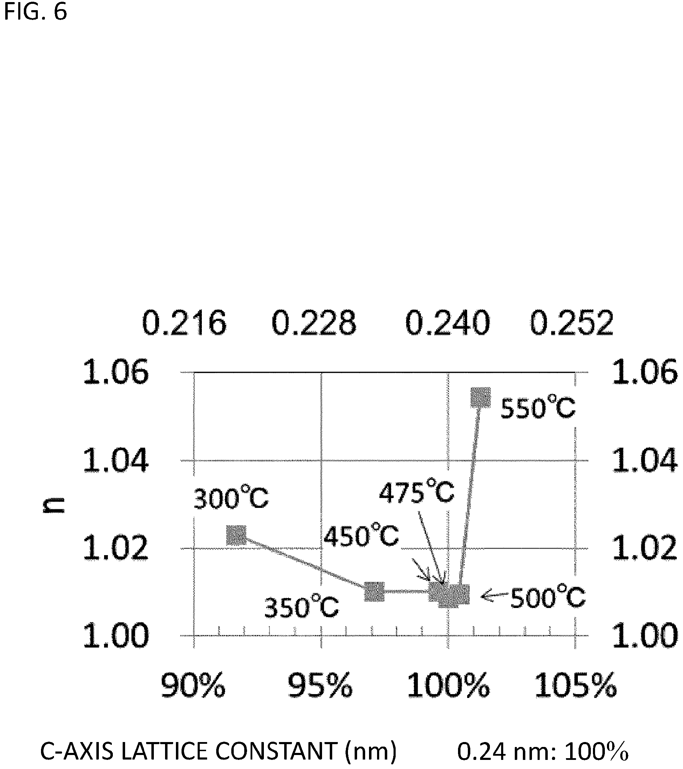

Note that as shown in Fig. 4, it could be confirmed that ϕBn also decreased when the annealing was performed at 550°C or higher, while as shown in Fig. 6, when the annealing was performed at 550°C or higher, the n value (ideal factor) was deteriorated. This is considered to be because a chemical reaction occurs between the Ti layer and the silicon carbide layer 12. The value (C-axis lattice constant) on the horizontal axis shown in Fig. 6 also represents a lattice constant when the cumulative probability is 30%, similarly to Fig. 4.

### (Manufacturing example 2, which does not form part of the invention)

Next, another manufacturing example different from the above will be described. Similarly to the manufacturing example 1, a Ti layer is deposited on a substrate in which the silicon carbide layer 12 is provided on the silicon carbide substrate 11. For the deposition of the Ti layer, electron beam deposition may be used, or sputtering may be used. A deposition rate is, for example, 0.1 to 0.3 nm/s (e.g., 0.12 nm/s), and the degree of vacuum at the time of the deposition of the Ti layer is, for example, 1E-4 Pa to 1E-5 Pa (e.g., 1E-4 Pa).

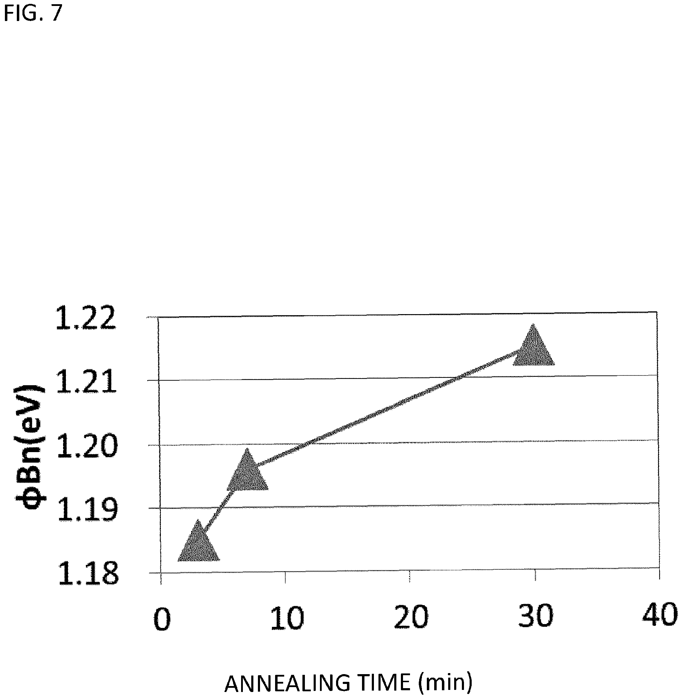

Next, the substrate provided with the Ti layer is annealed (heated) at 450°C to 500°C. The substrate provided with the Ti layer is annealed, for example, at 450°C for between 2 minutes and 10 minutes (inclusive) (e.g., 8 minutes). Fig. 7 is a graph showing a relationship between an annealing time when annealing is performed at 450°C and ϕBn (eV), and it can be confirmed that ϕBn (eV) decreases when the annealing time is short.

As described above, immediately after the Ti layer is deposited on the silicon carbide layer 12, a state is created at the interface between the silicon carbide layer 12 and the Ti layer, in which vacancies are included in the Ti layer. When the Ti layer is annealed, crystallized of Ti proceeds while the vacancies in the Ti layer are diffused outward. In this respect, even when annealing is performed at 450 to 500°C, the vacancies in the Ti layer are suppressed from being diffused outward by shortening the annealing time. Therefore, a state in which many vacancies are included in the Ti layer can be realized, and region, in which a lattice constant is smaller than that at the time of complete crystallization, can be formed by generating stress. As a result, ϕBn can be lowered.

### (Manufacturing example 3, which does not form part of the invention)

Next, a manufacturing example 3 different from the above manufacturing examples 1 and 2 will be described.

Also in the manufacturing example 3, a Ti layer is deposited on a substrate in which the silicon carbide layer 12 is provided on the silicon carbide substrate 11, similarly to the manufacturing examples 1 and 2. For the deposition of the Ti layer, electron beam deposition may be used, or sputtering may be used. However, a deposition rate in the manufacturing example 3 is set to be less than 0.02 nm/s. For example, the deposition rate may be, for example, 0.01 nm/s or less (e.g., 0.01 nm/s), and the degree of vacuum at the time of the deposition of the Ti layer is, for example, 1E-4 Pa to 1E-5 Pa (e.g., 1E-4 Pa).

Next, the substrate provided with the Ti layer is annealed (heated) at 450 to 500°C. The substrate provided with the Ti layer is annealed, for example, at 450°C for 30 minutes to 60 minutes (e.g., 30 minutes).

By reducing the deposition rate as in the present manufacturing example, the probability that molecules, atoms, ions, and the like other than Ti fly to the front surface of the silicon carbide layer 12 at the time of the deposition relatively increases. Therefore, a state is created in which more vacancies are included in the Ti layer at the interface between the Ti layer and the silicon carbide layer 12. Therefore, even when the annealing temperature is set to 450°C to 500°C and the annealing time is set to 30 minutes, more vacancies remain in the Ti layer. Therefore, region in which a lattice constant is smaller than that at the time of complete crystallization can be formed by generating stress, and ϕB can be lowered.

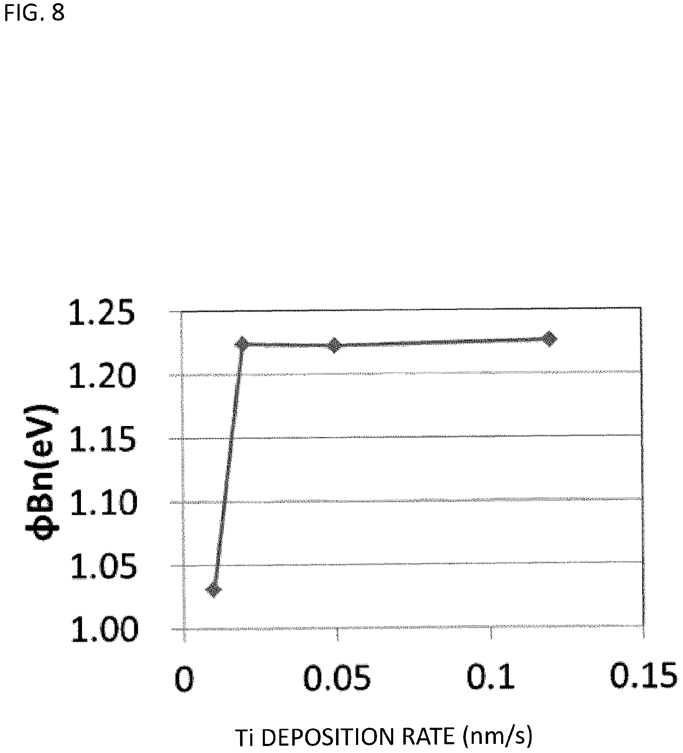

The results of changing, by the inventors of the present application, the deposition rate under conditions in which the annealing is performed at 450°C for 30 minutes are as shown in Table 1 below. These results are shown in Fig. 8.

**[Table 1]**

| Degree of vacuum (Pa) | Deposition rate (nm/s) | ϕBn (eV) |
|---|---|---|
| 1.00E-04 | 0.01 | 1.031 |
| 1.00E-04 | 0.02 | 1.224 |
| 1.00E-04 | 0.05 | 1.223 |
| 1.00E-04 | 0.12 | 1.226 |

### (Manufacturing example 4, which does not form part of the invention)

Next, a manufacturing example 4 different from the manufacturing examples 1 to 3 will be described.

Also in the manufacturing example 4, a Ti layer is deposited on a substrate in which the silicon carbide layer 12 is provided on the silicon carbide substrate 11, similarly to the manufacturing examples 1 to 3. For the deposition of the Ti layer, electron beam deposition may be used, or sputtering may be used. However, the degree of vacuum at the time of the deposition in the manufacturing example 4 is set to 5E-4 Pa or more. For example, a deposition rate is, for example, 0.1 to 0.3 nm/s (e.g., 0.12 nm/s), and the degree of vacuum at the time of the deposition of the Ti layer is 5E-4 Pa or more (e.g., 9.3E-4 Pa). If the degree of vacuum is excessively increased, various problems occur, and thus the upper limit value is 1E-2 Pa.

Next, the substrate provided with the Ti layer is annealed (heated) at 450 to 500°C. The substrate provided with the Ti layer is annealed, for example, at 450°C for 30 minutes to 60 minutes (e.g., 30 minutes).

By increasing the degree of vacuum as in the present manufacturing example, the probability that molecules, atoms, ions, and the like other than Ti fly to the front surface of the silicon carbide layer 12 at the time of the deposition relatively increases. Therefore, a state is created in which more vacancies are included in the Ti layer at the interface between the Ti layer and the silicon carbide layer 12. Therefore, even when the annealing temperature is set to 450 to 500°C and the annealing time is set to 30 minutes, more vacancies remain in the Ti layer. Therefore, region in which a lattice constant is smaller than that at the time of complete crystallization can be formed by generating stress, and ϕBn can be lowered.

The results of the inventors of the present application setting the degree of vacuum to 9.3E-4 Pa under conditions in which the annealing is performed at 450°C for 30 minutes are as shown in Table 2 below, and it could be confirmed that ϕBn could be lowered.

**[Table 2]**

| Degree of vacuum (Pa) | Deposition rate (nm/s) | ϕBn (eV) |
|---|---|---|
| 9.30E-04 | 0.12 | 1.18 |

### <<Effects>>

Next, effects of the present embodiment having the above-described configuration will be described. Note that all aspects described in the "effects" can be adopted in the above configuration.

In the present embodiment, when an aspect is adopted in which the single crystal layer 21 in the interface region of the metal electrode 20 includes first region in which the C-axis lattice constant L1 is smaller than the lattice constant L in an equilibrium state by 1.5% to 8%, ϕBn can be lowered without changing the material of the metal electrode 20.

When the single crystal layer 21 in the interface region includes the first region, in which the C-axis lattice constant is L1 (value smaller than L by 1.5% to 8%), at 20% or more, ϕBn can be lowered more reliably. In addition, when the single crystal layer 21 in the interface region includes the first region, in which the C-axis lattice constant is L1 (value smaller than L by 1.5% to 8%), at 30% or more, ϕBn can be lowered even more reliably (see Fig. 3 and Fig. 4).

When the metal electrode 20 in the interface region contains hexagonal Ti and the silicon carbide layer 12 in contact with the Ti has a hexagonal structure, ϕBn can be lowered more reliably.

When the single crystal layer 21 in the interface region contains Ti, the originally low ϕBn can be further lowered, and when the single crystal layer includes the first region containing Ti in which the C-axis lattice constant L1 is 0.235 nm or less, ϕBn can be lowered more reliably.

The description of the embodiments and the disclosure of the drawings described above are merely examples for describing the invention described in the claims, and the invention described in the claims is not limited by the description of the embodiments or the disclosure of the drawings described above.

### REFERENCE SIGNS LIST

- 12: silicon carbide layer (wide gap semiconductor layer)
- 20: metal electrode
- 21: single crystal layer

## Claims

1. A silicon carbide device comprising:
a silicon carbide layer (12); and
a metal layer provided on the silicon carbide layer (12),
wherein the metal layer has a single crystal layer (21) in an interface region at an interface with the silicon carbide layer (12),
when it is assumed that a lattice constant, in an equilibrium state, of a metal constituting the metal layer is L, the single crystal layer (21) in the interface region includes a first region in which a lattice constant L1 is smaller than L by 1.5% to 8%.

2. The silicon carbide device according to claim 1,
wherein the lattice constant L and the lattice constant L1 are a lattice constant of C-axis.

3. The silicon carbide device according to claim 1,
wherein the single crystal layer (21) in the interface region includes the first region at 20% or more.

4. The silicon carbide device according to claim 1,
wherein the single crystal layer (21) in the interface region includes a second region in which the lattice constant L1 is larger than L, and
wherein the first region occupies a wider region than the second region in the interface region.

5. The silicon carbide device according to claim 1,
wherein the silicon carbide layer (12) has a hexagonal structure,
wherein a crystal structure of the metal layer has a hexagonal structure, and
wherein the metal of the metal layer is Ti.

6. The silicon carbide device according to claim 1,
wherein the single crystal layer (21) in the interface region includes a first region made of Ti in which the lattice constant L1 is 0.235 nm or less.

7. The silicon carbide device according to claim6,
wherein the single crystal layer (21) in the interface region includes a first region made of Ti, in which the lattice constant L1 is 0.235 nm or less, at 20% or more.

8. A method for manufacturing a silicon carbide device comprising steps of
depositing a Ti layer on a silicon carbide layer (12); and
heating the Ti layer at 350°C or lower,
wherein the Ti layer has a single crystal layer (21) in an interface region at an interface between the silicon carbide layer (12) and the Ti layer.

## Patentansprüche

1. Siliziumkarbidvorrichtung, umfassend:
eine Siliziumkarbidschicht (12); und
eine Metallschicht, die auf der Siliziumkarbidschicht (12) angebracht ist,
wobei die Metallschicht eine Einkristallschicht (21) in einem Grenzflächenbereich an einer Grenzfläche mit der Siliziumkarbidschicht (12) aufweist,
wenn angenommen wird, dass eine Gitterkonstante eines die Metallschicht bildenden Metalls im Gleichgewichtszustand L ist, die Einkristallschicht (21) im Grenzflächenbereich einen ersten Bereich umfasst, in dem eine Gitterkonstante L1 um 1,5 % bis 8 % kleiner als L ist.

2. Siliziumkarbidvorrichtung nach Anspruch 1,
wobei die Gitterkonstante L und die Gitterkonstante L1 eine Gitterkonstante der C-Achse sind.

3. Siliziumkarbidvorrichtung nach Anspruch 1,
wobei die Einkristallschicht (21) im Grenzflächenbereich den ersten Bereich zu 20 % oder mehr einschließt.

4. Siliziumkarbidvorrichtung nach Anspruch 1,
wobei die Einkristallschicht (21) im Grenzflächenbereich einen zweiten Bereich enthält, in dem die Gitterkonstante L1 größer als L ist, und
wobei der erste Bereich einen breiteren Bereich als der zweite Bereich im Schnittstellenbereich einnimmt.

5. Siliziumkarbidvorrichtung nach Anspruch 1,
wobei die Siliziumkarbidschicht (12) eine hexagonale Struktur aufweist,
wobei eine Kristallstruktur der Metallschicht eine hexagonale Struktur aufweist, und
wobei das Metall der Metallschicht Ti ist.

6. Siliziumkarbidvorrichtung nach Anspruch 1,
wobei die Einkristallschicht (21) im Grenzflächenbereich einen ersten Bereich aus Ti enthält, in dem die Gitterkonstante L1 0,235 nm oder weniger beträgt.

7. Siliziumkarbidvorrichtung nach Anspruch 6,
wobei die Einkristallschicht (21) im Grenzflächenbereich einen ersten Bereich aus Ti enthält, in dem die Gitterkonstante L1 0,235 nm oder weniger beträgt, bei 20 % oder mehr.

8. Verfahren zur Herstellung einer Siliziumkarbidvorrichtung, das die folgenden Schritte umfasst
Abscheiden einer Ti-Schicht auf einer Siliziumkarbidschicht (12); und
Erhitzen der Ti-Schicht auf 350°C oder weniger,
wobei die Ti-Schicht eine Einkristallschicht (21) in einem Grenzflächenbereich an einer Grenzfläche zwischen der Siliziumkarbidschicht (12) und der Ti-Schicht aufweist.

## Revendications

1. Dispositif à carbure de silicium, comprenant :
une couche de carbure de silicium (12) ; et
une couche métallique prévue sur la couche de carbure de silicium (12),
dans lequel la couche métallique comporte une couche monocristalline (21) dans une région d'interface à une interface avec la couche de carbure de silicium (12),
lorsqu'il est supposé qu'une constante de réseau, dans un état d'équilibre, d'un métal constituant la couche métallique est L, la couche monocristalline (21) dans la région d'interface comprend une première région dans laquelle une constante de réseau L1 est inférieure à L de 1,5 % à 8 %.

2. Dispositif à carbure de silicium selon la revendication 1,
dans lequel la constante de réseau L et la constante de réseau L1 sont une constante de réseau d'axe C.

3. Dispositif à carbure de silicium selon la revendication 1,
dans lequel la couche monocristalline (21) dans la région d'interface comprend la première région à 20 % ou plus.

4. Dispositif à carbure de silicium selon la revendication 1,
dans lequel la couche monocristalline (21) dans la région d'interface comprend une seconde région dans laquelle la constante de réseau L1 est supérieure à L, et
dans lequel la première région occupe une région plus large que la seconde région dans la région d'interface.

5. Dispositif à carbure de silicium selon la revendication 1,
dans lequel la couche de carbure de silicium (12) présente une structure hexagonale, dans lequel une structure cristalline de la couche métallique présente une structure hexagonale, et
dans lequel le métal de la couche de métal est Ti.

6. Dispositif à carbure de silicium selon la revendication 1,
dans lequel la couche monocristalline (21) dans la région d'interface comprend une première région constituée de Ti dans laquelle la constante de réseau L1 est de 0,235 nm ou moins.

7. Dispositif à carbure de silicium selon la revendication 6,
dans lequel la couche monocristalline (21) dans la région d'interface comprend une première région constituée de Ti, dans laquelle la constante de réseau L1 est de 0,235 nm ou moins, à 20 % ou plus.

8. Procédé de fabrication d'un dispositif à carbure de silicium comprenant les étapes consistant à
déposer une couche de Ti sur une couche de carbure de silicium (12) ; et
chauffer la couche de Ti à 350°C ou moins,
dans lequel la couche de Ti comporte une couche monocristalline (21) dans une région d'interface au niveau d'une interface entre la couche de carbure de silicium (12) et la couche de Ti.
